Europäisches Patentamt

European Patent Office

Office européen des brevets

(11) Publication number : **0 421 446 B1**

(12) # EUROPEAN PATENT SPECIFICATION

(45) Date of publication of patent specification :
28.12.94 Bulletin 94/52

(51) Int. Cl.⁵ : **H01L 27/115, H01L 27/092**

(21) Application number : 90119100.7

(22) Date of filing : 05.10.90

(54) **Semiconductor device wherein n-channel MOSFET, p-channel MOSFET and nonvolatile memory cell are formed in one chip.**

(30) Priority : 06.10.89 JP 261569/89

(43) Date of publication of application :
10.04.91 Bulletin 91/15

(45) Publication of the grant of the patent :
28.12.94 Bulletin 94/52

(84) Designated Contracting States :
DE FR GB

(56) References cited :
WO-A-87/05443
ELECTRICAL DESIGN NEWS, vol. 30, no. 25, November 1985, pages 145-152,154; D.COR-MIER: "Erasable/programmable solid-state memories"
ELECTRONICS, vol. 61, no. 10, 12th May 1988, pages 70,71, New York, US; "TI's erasable PLDs are fast but don't need much power"
ELECTRONIC DESIGN, vol. 31, no. 20, September 1983, pages 44,46, Waseca, MN,Denville, NJ, US; M. GOLD: "VLSI process advances herald the coming ofsuperfast computers"
(73) Proprietor : **Kabushiki Kaisha Toshiba**
**72, Horikawa-cho**
**Saiwai-ku**
**Kawasaki-shi (JP)**

(72) Inventor : **Uemura, Teruo, c/o Intellectual**
**Property Div.**
**Kabushiki Kaisha Toshiba,**
**1-1 Shibaura 1-chome**
**Minato-ku, Tokyo 105 (JP)**
Inventor : **Hanada, Naoki, c/o Intellectual**
**Property Div.**
**Kabushiki Kaisha Toshiba,**
**1-1 Shibaura 1-chome**
**Minato-ku, Tokyo 105 (JP)**

(74) Representative : **Lehn, Werner, Dipl.-Ing. et al**
**Hoffmann, Eitle & Partner,**
**Patentanwälte,**
**Postfach 81 04 20**
**D-81904 München (DE)**

## Description

The present invention generally relates to a semiconductor device comprising: a semiconductor substrate which has a major surface and is of a first conductivity type; a first active element and a second active element, different from the first, formed in the major surface of the semiconductor substrate; a well region which is formed in the major surface of the substrate and is of a second conductivity type; a third active element formed in a surface region of the well region.

Such a semiconductor device is known from Electrical Design News, Vol. 30, No. 25, November 1985, pp. 145 - 152, 154.

Preferably, it relates to a semiconductor device wherein an n-channel MOSFET, a p-channel MOSFET and a nonvolatile memory cell are formed in one chip.

An EPROM, which is an example of a nonvolatile semiconductor memory device is made up mainly of a group of EPROM memory cells, and a peripheral circuit such as a decoder used for selecting the memory cells. In general, the peripheral circuit is constituted by a MOSFET. Presently-available MOSFETs include an n-channel MOSFET and a p-channel MOSFET, and an EPROM whose peripheral circuit is formed by using these two types of MOSFETs is generally referred to as a CMOS-type EPROM.

In the CMOS-type EPROM which is known from the above cited paper, an n-channel MOSFET and an n-channel EPROM memory cell are formed in the major surface of a p-type silicon substrate, and a p-channel type MOSFET is formed on the surface of an n-type well region provided in the p-type silicon substrate.

In the n-channel EPROM memory cell, hot electrons are generated in the channel region of the memory cell transistor, and data writing is carried out, with the hot electrons being captured in a floating gate. The hot electrons have to be implanted into each of a number of floating gates with no deviation. In other words, it is required that the electron concentrations in the floating gates be uniform. To meet with this requirement, the EPROM memory cells are formed on the substrate surface where the impurity concentrations are uniform and stable, and the entire memory cell region is applied with a uniform electric field. It should be noted that the impurity concentration in the substrate is determined in accordance with the characteristics of the EPROM memory cell.

In the circuit section formed by an n-channel MOSFET and a p-channel MOSFET, so-called latch-up becomes a problem. The latch-up is a phenomenon observed in the case where the n-channel MOSFET and the p-channel MOSFET are formed on the same substrate. In this case, a parasitic thyristor within the substrate may be turned on, resulting in a continuous current flow between the two MOSFETs. If the latch-up occurs, the circuit may become out of order; in some cases, it may be broken. If the n-channel MOSFET and the p-channel MOSFET are miniaturized, the latch-up becomes very likely to occur.

In the CMOS-type EPROM, the impurity concentration in the substrate is increased, so as to prevent the latch-up between the n-channel MOSFET and the p-channel MOSFET.

In the above method for preventing latch-up, however, it is difficult to increase the impurity concentration in the substrate to an optimal degree, and the impurity concentration in the substrate is liable to become high. If the impurity concentration is too high, the EPROM memory cell may have different characteristics, for example, the different writing speeds. If the two types of elements are further miniaturized, the latch-up becomes more likely to occur, so that the reliability of the device is degraded very much.

Accordingly, an object the present invention is to provide a semiconductor device which allows miniaturization of both an n-channel MOSFET and a p-channel MOSFET, without degrading the reliability of a nonvolatile memory cell, such as an EPROM.

This object is achieved according to the following features of claim 1: a first well region which is formed in.the major surface of the substrate and is of a first conductivity type in which said second active element is formed; wherein the impurity concentration of the substrate is determined in accordance with the characteristics of the first active element, and the impurity concentrations in the first and second well regions are determined to prevent latch-up therebetween.

Preferred embodiments are listed in the dependent claims.

In the above semiconductor device, the carrier accumulation means is located above the major surface of the semiconductor substrate of the first conductivity type. Therefore, a nonvolatile memory cell is reliable in operation, particularly in data writing. In addition, the first well region of the first conductivity type and the second well region of the second conductivity type are formed in the major surface of the semiconductor substrate, and MOSFETs are formed in the first and second well regions, respectively. With this structure, latch-up is prevented from occurring between the MOSFETs, without degrading the reliability of the non-volatile memory cell. For example, the reliability of data writing and high breakdown voltage are in no way adversely affected by the prevention of latch-up.

This invention can be more fully understood from the following detailed description when taken in conjunction with the accompanying drawings, in which:

Fig. 1 is a sectional view of an EPROM according to one embodiment of the present invention; and

Figs. 2A-2J are sectional views illustrating how the EPROM shown in Fig. 1 is manufactured.

A nonvolatile semiconductor memory device according to one embodiment of the present invention will now be described, with reference to the accompanying drawings.

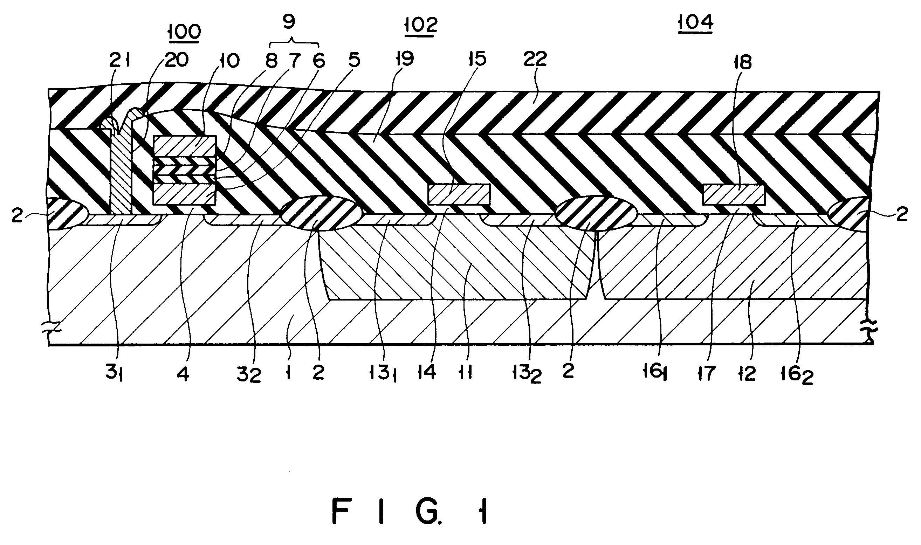

Fig. 1 is a sectional view of an EPROM which is an example of the nonvolatile semiconductor memory device.

As is shown in Fig. 1, a field oxide film 2 used for element isolation is formed on the surface of a silicon substrate 1 of e.g. a p-type. N-type source/drain regions $3_1$ and $3_2$ are formed in the surface region of the p-type silicon substrate 1. A first gate insulation film 4 is formed on the substrate portion located between the source/drain regions $3_1$ and $3_2$, and the gate insulation film 4 is overlaid with a floating gate 5. A second gate insulation film 9, which is e.g. a triple-layered structure made up of a nitride film 6, an oxide film 7 and a nitride film 8, is formed on the floating gate 5. A control gate 10 is formed on the second gate insulation film 9. By these structural elements, an n-channel EPROM memory cell 100 is obtained. The n-channel EPROM memory cell of this structure is generally referred to as a SAMOS (a stacked-gate avalanche-injection MOS).

A p-type well region 11 and an n-type well region 12 are formed in the surface region of the substrate 1. In the surface region of the p-type well region 11, n-type source/drain regions $13_1$ and $13_2$ are formed. A gate insulation film 14 is formed on that surface portion of the p-type well region 11 which is located between the n-type source/drain regions $13_1$ and $13_2$, and a gate 15 is formed on the gate insulation film 14. By these structural elements, an n-channel MOSFET 102 is constituted. In the surface region of the n-type well region 12, p-type source/drain regions $16_1$ and $16_2$ are formed. A gate insulation film 17 is formed on that surface portion of the p-type well region 11 which is located between the source/drain regions $16_1$ and $16_2$, and a gate 18 is formed on the gate insulation film 17. By these structural elements, a p-channel MOSFET 104 is constituted. The n-channel MOSFET 102 and the p-channel MOSFET 104 are used as elements of a decoder circuit or a logic circuit. The entire surface of the semiconductor device is covered with an interlayer insulation film 19, and a contact hole 20 leading to a predetermined point of the semiconductor device is formed in the interlayer insulation film 19. A wiring line 20, made of e.g. aluminum and connected to the predetermined point of the semiconductor device through the contact hole 20, is formed on the interlayer insulation film 19. A surface protection layer 22 is formed on the entire surface of the semiconductor device.

In the EPROM mentioned above, the memory cell 100 is formed on the p-type silicon substrate 1 in which impurities are distributed in a stable manner. Since an electric field is applied uniformly applied to the whole of the memory cell region, electrons can be implanted, with no deviation, into each of a large number of floating gates existing in the memory cell region. Accordingly, the memory cell 100 is very reliable in operation, particularly in data writing.

Moreover, the n-channel MOSFET 102 and the p-channel MOSFET 104 are provided for the p-type well region 11 and the n-type well region 12, respectively. In the case where the impurity concentration in the p-type well region 11 is made higher than that in the p-type substrate 1, latch-up is prevented from occurring even if the n-channel MOSFET 102 is miniaturized. Likewise, in the case where the impurity concentration in the n-type well region 12 is increased, latch-up is prevented from occurring even if the p-channel MOSFET 104 is miniaturized. More specifically, if the impurity concentrations in the p-type and n-type well regions 11 and 12 are increased, the base of a parasitic bipolar transistor which would form a parasitic thyristor will have an increased impurity concentration. Since, therefore, the parasitic bipolar transistor becomes hard to turn on, latch-up is reliably prevented from occurring.

As mentioned above, in the EPROM of the embodiment of the present invention, the n-channel EPROM memory cell 100 is provided for the p-type silicon substrate 1, while the n-channel MOSFET 102 is provided for the p-type well region 11. Since the n-channel EPROM memory cell 100 and the n-channel MOSFET 102 are therefore isolated from each other, the n-channel MOSFET 102 and the p-channel MOSFET 104 (which are used as a logic circuit, an EPROM's peripheral circuit [e.g., a decoder]) can be miniaturized, without adversely affecting the reliability of the EPROM memory cell 100 (for example, the reliability of data writing and the high breakdown voltage are not adversely affected). It should be also noted that the occurrence of latch-up is prevented even in the case where the n-channel and p-channel MOSFETs 102 and 104 are miniaturized.

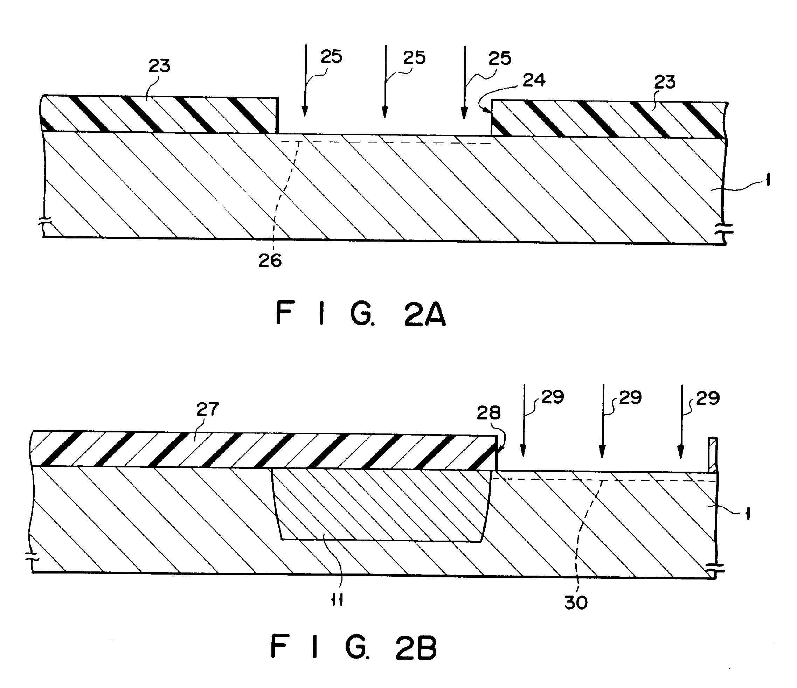

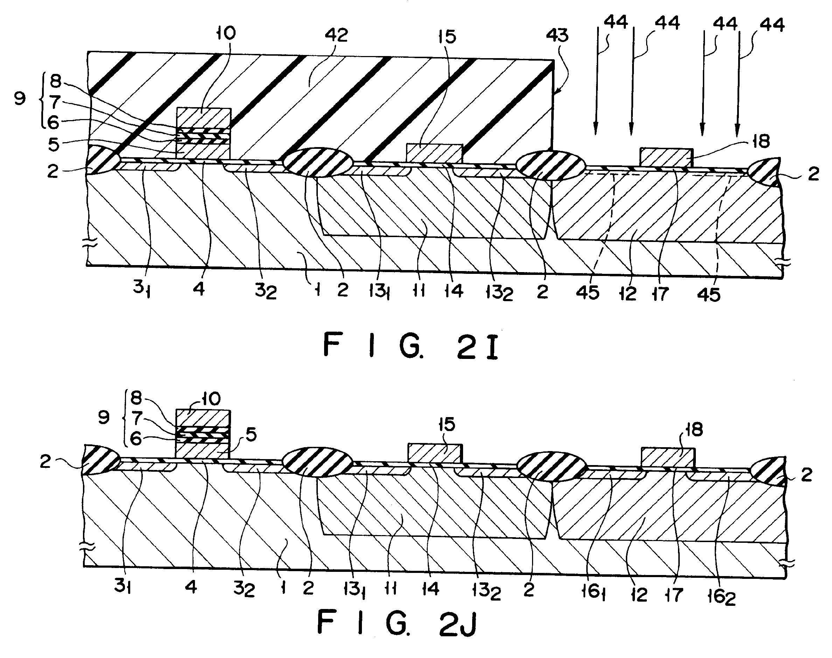

A description will now be given as to how the EPROM of the above embodiment is manufactured, with reference to Figs. 2A through 2J. These Figures are sectional views illustrating the EPROM in the order of manufacture. In the Figures, the same reference numerals as are used in Fig. 1 are used to indicate the same or corresponding structural elements shown in Fig. 1.

Referring first to Fig. 2A, a p-type silicon substrate 1 having an impurity concentration of $1 \times 10^{15}$ $cm^{-3}$ or so is prepared. An oxide film (not shown) is formed on surface of this substrate 1 by oxidation, and then photoresist 23 is coated on the entire surface of the resultant structure. A hole 24 is formed in the photoresist 23 by photographic etching such that the hole 24 corresponds to the pattern of a p-type well region to be formed later. Thereafter, p-type impurities, such as boron 25, are ion-implanted into the substrate 1 with a dose of $1 \times 10^{12}$ $cm^{-2}$ or so, using the photoresist 23 as a mask. In Fig. 2A, the region into which the boron 25 is ion-implanted is indicated by reference numeral 26.

As is shown in Fig. 2B, the photoresist 23 is removed, and then the ion-implanted boron is thermally diffused by subjecting the semiconductor structure to heat treatment. By this heat treatment, a p-type well region 11 whose impurity concentration is $1 \times 10^{16}$ cm$^{-3}$ or so is formed in the substrate 1. Subsequently, photoresist 27 is coated on the entire surface of the resultant semiconductor structure. A hole 28 is formed in the photoresist 27 by photographic etching such that the hole 28 corresponds to the pattern of an n-type well region to be formed later. Thereafter, n-type impurities, such as phosphorus 29, are ion-implanted into the substrate 1 with a dose of $1 \times 10^{12}$ cm$^{-2}$ or so, using the photoresist 27 as a mask. In Fig. 2B, the region into which the arsenic 29 is ion-implanted is indicated by reference numeral 30.

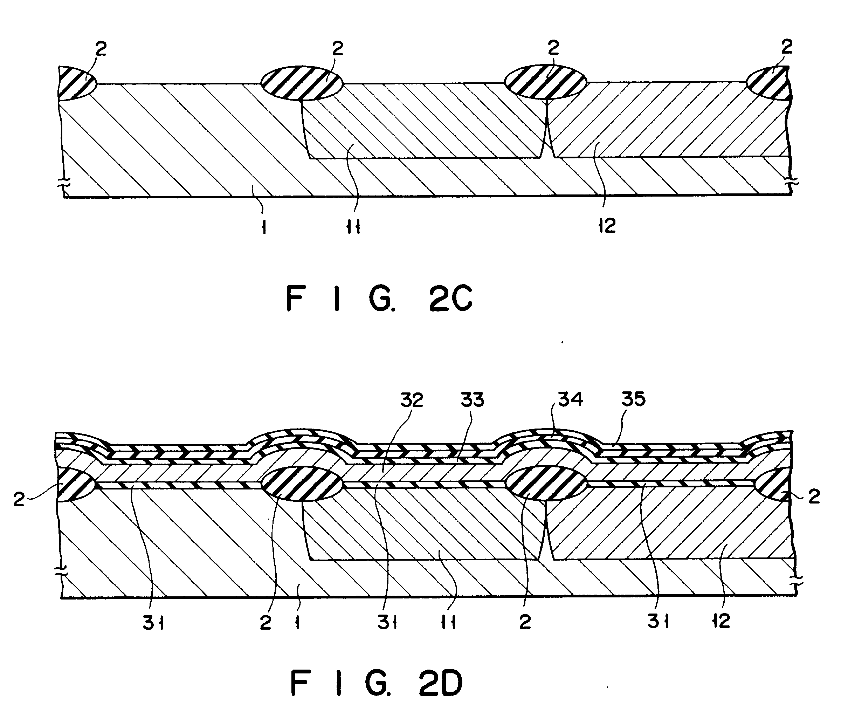

As is shown in Fig. 2C, the photoresist 27 is removed, and then the ion-implanted phosphorus is thermally diffused by subjecting the semiconductor structure to heat treatment. By this heat treatment, an n-type well region 12 whose impurity concentration is $1 \times 10^{16}$ cm$^{-3}$ or so is formed in the substrate 1. Next, a field oxide film 2 is formed by use of e.g. a LOCOS method, for the purpose of element isolation.

Incidentally, the ion implantation of the p-type impurities used for forming the p-type well region and the ion implantation of the n-type impurities used for forming the n-type well region need not be carried out in the above-mentioned order. That is, the ion implantation of the n-type impurities may be carried out first, being followed by the ion implantation of the p-type impurities.

After the p-type and n-type well regions are formed as above, impurities may be ion-implanted into the channel region of an EPROM memory cell transistor, so as to control the threshold value of this transistor.

As is shown in Fig. 2D, a thermal oxide film 31 is formed on the exposed surface portions of the substrate by thermal oxidation. The thermal oxide film 31 is used as the first gate insulation film of the EPROM memory cell transistor. Next, a first polysilicon layer 32 is formed on the entire surface of the semiconductor structure. With respect to the first polysilicon layer 32, phosphorus diffusion is performed by use of POC$\ell_3$. By this phosphorus diffusion, the first polysilicon layer 32 is rendered conductive, i.e., the resistance thereof is reduced. After the phosphorus diffusion, a thermal oxide layer 33 is formed on the surface of the first polysilicon layer 32 by thermal oxidation, a nitride film 34 is formed on the entire surface of the semiconductor structure by CVD, and a thermal oxide film 35 is formed on the surface of the nitride film 34 by thermal oxidation.

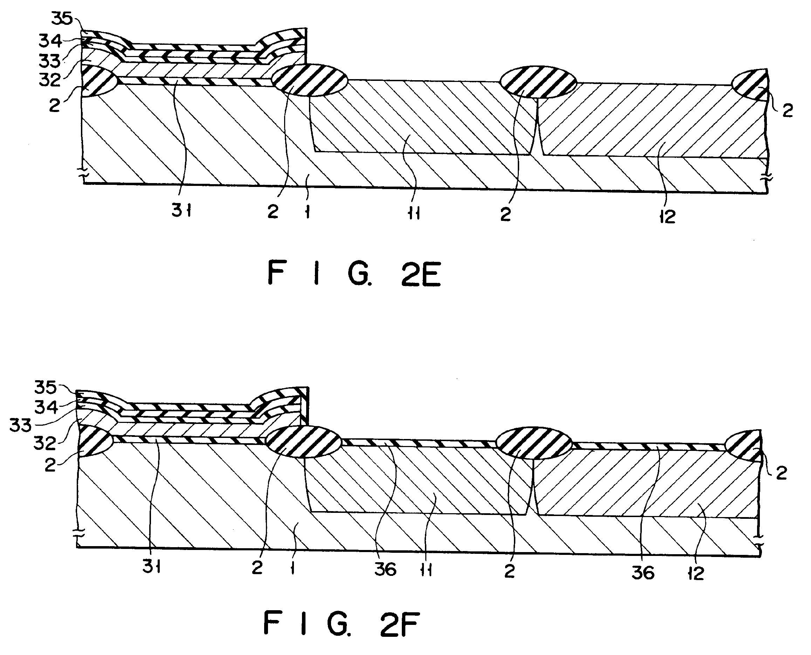

As is shown in Fig. 2E, the thermal oxide film 35, the nitride film 34, the thermal oxide film 33, the first polysilicon layer 32 and the thermal oxide film 31 are selectively removed by photographic etching, so as to expose that surface portion of the substrate 1 where the n-type well region 11 and the p-type well region 12 are formed.

During this etching step, a so-called "cell slit" (not shown) is formed in the EPROM memory cell region, such that the floating gate is divided into pieces for the respective EPROM memory cells.

After the etching step, impurities may be ion-implanted into the channel regions of the n-channel and p-channel MOSFETs, so as to control the threshold values of these transistors.

As is shown in Fig. 2F, a thermal oxide film 36 is formed, by thermal oxidation, on the exposed surface portions of the substrate and on the surface of the first polysilicon layer 32. This thermal oxide film 36 is used as a gate insulation film of the n-channel and p-channel MOSFETs.

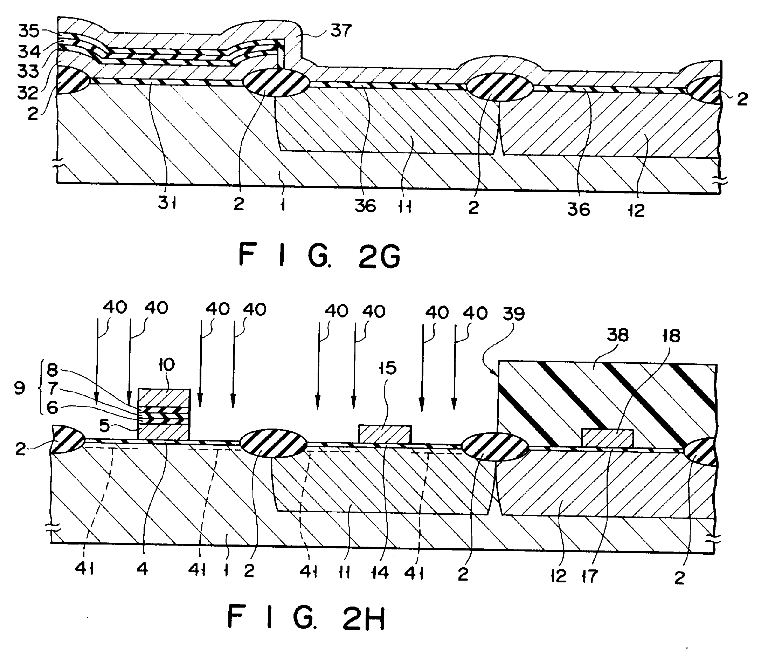

As is shown in Fig. 2G, a second polysilicon layer 37 is formed on the entire surface of the semiconductor structure by CVD, for example. With respect to the second polysilicon layer 37, phosphorus diffusion is performed by use of POC$\ell_3$. By this phosphorus diffusion, the second polysilicon layer 37 is rendered conductive, i.e., the resistance thereof is reduced.

As is shown in Fig. 2H, the second polysilicon layer 37 is selectively removed by photographic etching, such that gates 15 and 18 of the n-channel and p-channel MOSFETs are formed. During this etching step, the EPROM memory cell region are kept covered with photoresist (not shown). Next, the second polysilicon layer 37, the thermal oxide film 35, the nitride film 34, the thermal oxide film 33 and the first polysilicon layer 32 are selectively removed by photographic etching, such that a control gate 10, a second gate insulation film 9 and a floating gate 5 are formed for the EPROM memory cell. During this etching step, the regions of the n-channel and p-channel MOSFETs are kept covered with photoresist (not shown). Thereafter, photoresist 38 is coated on the entire surface of the semiconductor structure. A hole 39 is formed in the photoresist 38 by photographic etching such that the hole 39 corresponds to the region where both the EPROM memory cell and the n-channel MOSFET are formed. Thereafter, n-type impurities, such as arsenic or phosphorus 40, are ion-implanted into the substrate 1 and p-type well region 11, using the photoresist 38, the control gate 10, the gate 15, etc. as a mask. In Fig. 2H, the region into which the arsenic or phosphorus 40 is ion-implanted is indicated by reference numeral 41.

As is shown in Fig. 2I, photoresist 42 is formed on the entire surface of the semiconductor structure. A hole 43 is formed in the photoresist 42 by photographic etching such that the hole 43 corresponds to the region where the p-channel MOSFET is formed. Thereafter, p-type impurities, such as boron 44, are ion-implanted into the n-type well region 12, using the photoresist 42, the gate 18, etc. as a mask. In Fig. 2I, the region into which the boron is ion-implanted is indicated by reference numeral 45.

As is shown in Fig. 2J, the photoresist 42 is removed from the semiconductor structure. Subsequently, the semiconductor structure is subject to heat treatment, so as to thermally diffuse the ion-implanted impurities, namely, the arsenic (or phosphorus) and boron. As a result of this heat treatment, n-type source/drain regions $3_1$, $3_2$, $13_1$ and $13_2$ and p-type source/drain regions $16_1$ and $16_2$ are formed.

As is shown in Fig. 1, an interlayer insulation film 19 is formed on the entire surface of the semiconductor structure by CVD. A contact hole 20, which leads to a predetermined point of the semiconductor structure, is selectively formed in the interlayer insulation film 19 by photographic etching. Subsequently, an aluminum film is formed on the entire surface of the semiconductor structure by sputtering. Finally, the aluminum film is selectively removed by photographic etching, such that a wiring line 21 having a predetermined pattern is left on the interlayer insulation film 19.

In the method mentioned above, the EPROM of the embodiment of the present invention is manufactured.

By use of the manufacturing method mentioned above, an EPROM 100 which ensures reliable data writing and has a high breakdown voltage, and n-channel and p-channel MOSFETs 102 and 104 which are miniaturized but hardly undergo latch-up, can be provided for the same substrate.

Reference signs in the claims are intended for better understanding and shall not limit the scope.

## Claims

1. A semiconductor device comprising:
    a semiconductor substrate (1) which has a major surface and is of a first conductivity type;
    a first well region (11) which is formed in the major surface of the substrate (1) and is of the first conductivity type;
    a first active element (100) formed in the major surface of the semiconductor substrate (1) outside the first well region;
    a second active element (102) different from said first active element (100) and formed in a surface region of the first well region (11);
    a second well region (12) which is formed in the major surface of the substrate (1) and is of a second conductivity type; and
    a third active element (104) formed in a surface region of said second well region (12);
    wherein the impurity concentration of the substrate (1) is determined in accordance with the characteristics of the first active element (100), and the impurity concentrations in the first and second well regions (11,12) are determined to prevent latch-up therebetween.

2. A semiconductor device according to claim 1, characterized in that said first active element (100) is a nonvolatile memory cell.

3. A semiconductor device according to claims 1 or 2, characterized in that said nonvolatile memory cell includes a carrier accumulation means (5) for accumulating carriers.

4. A semiconductor device according to claim 3, characterized in that said carrier accumulation means (5) includes a conductive layer.

5. A semiconductor device according to one of claims 1 to 4, characterized in that said second and third active elements (102, 104) are MOSFETs, respectively.

6. A semiconductor device according to one of claims 1 to 5, characterized in that said substrate (11) has an impurity concentration of $\ell 1$, and said first well region (11) has an impurity concentration of $\ell 2$, said impurity concentration $\ell 1$ and $\ell 2$ having a relationship expressed by:
$$\ell 1 < \ell 2.$$

7. A semiconductor device according to claim 1, wherein said first active element (100) comprises
    first and second semiconductor regions ($3_1$, $3_2$) which are formed in the major surface of the substrate (1) while being isolated from each other and which are of a second conductivity type;
    a carrier accumulation means (5) for accumulating carriers, said carrier accumulation means being formed above that surface portion of the substrate (1) which is located between the first and second semiconductor regions ($3_1$, $3_2$);
    a first insulation means (4), located between the carrier accumulation means (5) and the substrate (1), for electrically insulating the carrier accumulation means (5) and the substrate (1) from each other;
    a first conductive layer (10) formed above the carrier accumulation means (5); and
    second insulation means (9), located between the first conductive layer (10) and the carrier accumulation means (5), for electrically insulating the first conductive layer (10) and the carrier accumulation means (5) from each other;
    said second active element (102) comprising

third and fourth semiconductor regions ($13_1$, $13_2$) which are formed in a surface region of the first well region (11) while being isolated from each other and which are of the second conductivity type;

a second conductive layer (15) formed above that surface portion of the first well region (11) which is located between the third and fourth semiconductor regions ($13_1$, $13_2$); and

a third insulation means (14), located between the second conductive layer (15) and the first well region (11), for electrically insulating the second conductive layer (15) and the first well region (11) from each other; and

said third active element (104) comprising fifth and sixth semiconductor regions ($16_1$, $16_2$) which are formed in a surface region of the second well region (12) while being isolated from each other and which are of the first conductivity type;

a third conductive layer (18) formed above that surface portion of the second well region (12) which is located between the fifth and sixth semiconductor regions ($16_1$, $16_2$); and

fourth insulation means (17), located between the third conductive layer (18) and the second well region (12), for electrically insulating the third conductive layer (18) and the second well region (12) from each other.

8. A semiconductor device according to claim 7, characterized in that said first, second, third and fourth insulation means (4, 9, 14, 17) include insulation films, respectively.

9. A semiconductor device according to claim 7 or 8, characterized in that said carrier accumulation means (5) include a fourth conductive layer.

**Patentansprüche**

1. Halbleitervorrichtung mit:
einem Halbleitersubstrat (1), welches eine Hauptoberfläche hat und von einem ersten Leitungstyp ist;
einem ersten Wallbereich (11), der in der Hauptoberfläche des Substrats (1) gebildet ist und vom ersten Leitungstyp ist;
einem ersten aktiven Element (100), welches in der Hauptoberfläche des Halbleitersubstrats (1) außerhalb des ersten Wallbereichs gebildet ist;
einem zweiten aktiven Element (102), das von dem ersten aktiven Element (100) verschieden ist und das gebildet ist in einem Oberflächenbereich des ersten Wallbereichs (11);
einem zweiten Wallbereich (12), der in der Hauptoberfläche des Substrats (1) gebildet ist und von einem zweiten Leitungstyp ist; und
einem dritten aktiven Element (104), das in einem Oberflächenbereich des zweiten Wallbereichs (12) gebildet ist;
wobei die Verunreinigungskonzentration des Substrats (1) bestimmt ist in Übereinstimmung mit den Charakterisitika des ersten aktiven Elements (100), und die Verunreinigungskonzentrationen in den ersten und zweiten Wallbereichen (11, 12) bestimmt sind, einen Latch-up dazwischen zu verhindern.

2. Halbleitervorrichtung nach Anspruch 1, dadurch gekennzeichnet, daß das erste aktive Element (100) eine nicht-flüchtige Speicherzelle ist.

3. Halbleitervorrichtung nach Anspruch 1 oder 2, dadurch gekennzeichnet, daß die nicht-flüchtige Speicherzelle eine Ladungsträgerakkummulierungseinrichtung (5) zum Akkummulieren von Ladungsträgern beinhaltet.

4. Halbleitervorrichtung nach Anspruch 3, dadurch gekennzeichnet, daß die Ladungsträger-akkummulierungseinrichtung (5) eine leitende Schicht beinhaltet.

5. Halbleitervorrichtung nach einem der Ansprüche 1 bis 4, dadurch gekennzeichnet, daß die zweiten und dritten aktiven Elemente (102, 104) MOSFETS sind.

6. Halbleitervorrichtung nach einem der Ansprüche 1 bis 5, dadurch gekennzeichnet, daß das Substrat (11) eine Verunreinigungskonzentration von Rho1 und der erste Wallbereich (11) eine Verunreinigungskonzentration von Rho2 hat, wobei die Verunreinigungskonzentrationen Rho1 und Rho2 eine Beziehung haben, die ausgedrückt ist durch:
Rho1 < Rho2.

7. Halbleitervorrichtung nach Anspruch 1, dadurch gekennzeichnet, daß das erste aktive Element (100) umfaßt:
erste und zweite Halbleiterbereiche ($3_1$, $3_2$), welche in der Hauptoberfläche des Substrats (1) gebildet sind, wobei sie voneinander isoliert sind, und welche von einem zweiten Leitungstyp sind;
eine Ladungsträgerakkumulierungseinrichtung (5) zum Akkummulieren von Ladungsträgern, wobei die Ladungsträgerakkummulierungseinrichtung gebildet ist oberhalb des Oberflächenabschnitts des Substrats (1), der angesiedelt ist zwischen den ersten und zweiten Halbleiterbereichen ($3_1$, $3_2$);
eine ersten Isolationsschicht (4), die angesiedelt ist zwischen der Ladungsträgerakkumulierungseinrichtung (5) und dem Substrat (1), zum elektrischen Isolieren der Ladungsträgerakkumulierungseinrichtung (5) und des Substrats (1) voneinander;

einer ersten leitenden Schicht (10), gebildet oberhalb der Ladungsträgerakkumulierungseinrichtung (5); und

einer zweiten Isolationseinrichtung (9), angesiedelt zwischen der ersten leitenden Schicht (10) und der Ladungsträgerakkumulierungseinrichtung (5), zum elektrischen Isolieren der ersten leitenden Schicht (10) und der Ladungsträgerakkumulierungseinrichtung (5) voneinander;

wobei das zweite aktive Element (102) umfaßt:

dritte und vierte Halbleiterbereiche ($13_1$, $13_2$), welche in einem Oberflächenbereich des ersten Wallbereichs (11) gebildet sind, wobei sie voneinander isoliert sind und welche vom zweiten Leitungstyp sind;

eine zweite leitende Schicht (15), die oberhalb des Oberflächenabschnitts des ersten Wallbereichs (11) gebildet ist, welche angesiedelt ist zwischen dem dritten und vierten Halbleiterbereichen ($13_1$, und $13_2$); und

eine dritte Isolationseinrichtung (14), angesiedelt zwischen der zweiten leitenden Schicht (15) und dem ersten Wallbereich (11), zum elektrischen Isolieren der zweiten leitenden Schicht (15) und des ersten Wallbereichs (11) voneinander; und

wobei das dritte aktive Element (104) umfaßt:

fünfte und sechste Halbleiterbereiche ($16_1$, $16_2$), welche gebildet sind in einem Oberflächenbereich des zweiten Wallbereichs (12), wobei sie voneinander isoliert sind und welche vom ersten Leitungstyp sind;

eine dritte leitende Schicht (18), gebildet oberhalb des Oberflächenabschnitts des zweiten Wallbereichs (12), welche angesiedelt ist zwischen dem fünften und sechsten Halbleiterbereichen ($16_1$, $16_2$); und

eine vierte Isolationsschicht (17), angesiedelt zwischen der dritten leitenden Schicht (18) und dem zweiten Wallbereich (12), zum elektrischen Isolieren der dritten leitenden Schicht (18) und des zweiten Wallbereichs (12) voneinander.

**8.** Halbleitervorrichtung nach Anspruch 7, dadurch gekennzeichnet, daß die erste, zweite und vierte Isolationseinrichtung (4, 9, 14, 17) jeweils Isolationsfilme beinhalten.

**9.** Halbleitervorrichtung nach Anspruch 7 oder 8, dadurch gekennzeichnet, daß die Ladungsträger-Akkummulierungseinrichtung (5) eine vierte leitende Schicht beinhaltet.

**Revendications**

**1.** Dispositif à semiconducteurs comportant :

un substrat semiconducteur (1) qui possède une surface principale et est d'un premier type de conductivité ;

une première région de puits (11) qui est formée dans la surface principale du substrat (1) et est du premier type de conductivité ;

un premier élément actif (100) formé dans la surface principale du substrat semiconducteur (1) à l'extérieur de la première région de puits ;

un second élément actif (102) différent dudit premier élément actif (100) et formé dans une région superficielle de la première région de puits (11) ;

une seconde région de puits (12) formée dans la surface principale du substrat (1) et d'un second type de conductivité ; et

un troisième élément actif (104) formé dans une région superficielle de ladite seconde région de puits (12),

dans lequel la concentration en impuretés du substrat (1) est déterminée conformément aux caractéristiques du premier élément actif (100), et les concentrations en impuretés dans les première et seconde régions de puits (11 , 12) sont déterminées pour empêcher un blocage entre elles.

**2.** Dispositif à semiconducteurs selon la revendication 1, caractérisé en ce que ledit premier élément actif (100) est une cellule de mémoire non volatile.

**3.** Dispositif à semiconducteurs selon les revendications 1 ou 2, caractérisé en ce que ladite cellule de mémoire non volatile comprend un moyen d'accumulation de porteurs (5) en vue d'accumuler des porteurs.

**4.** Dispositif à semiconducteurs selon la revendication 3, caractérisé en ce que ledit moyen d'accumulation de porteurs (5) comprend une couche conductrice.

**5.** Dispositif à semiconducteurs selon l'une des revendications 1 à 4, caractérisé en ce que lesdits second et troisième éléments actifs (102, 104) sont des MOSFET, respectivement.

**6.** Dispositif à semiconducteurs selon l'une des revendications 1 à 5, caractérisé en ce que ledit substrat (1) possède une concentration en impuretés de $\ell 1$, et ladite première région de puits (11) possède une concentration en impuretés de $\ell 2$, lesdites concentrations en impuretés $\ell 1$ et $\ell 2$ ayant une relation exprimée par :

$$\ell 1 < \ell 2.$$

**7.** Dispositif à semiconducteurs selon la revendication 1, dans lequel ledit premier élément actif (100) comporte

des première et seconde régions semiconductrices ($3_1$, $3_2$) qui sont formées dans la surface principale du substrat (1) tout en étant isolées l'une de l'autre et qui sont d'un second type de conductivité ;

un moyen d'accumulation de porteurs (5) pour accumuler les porteurs, ledit moyen d'accumulation de porteurs étant formé au-dessus de la partie superficielle du substrat (1) qui est située entre les première et seconde régions semiconductrices ($3_1$, $3_2$) ;

un premier moyen d'isolement (4) situé entre le moyen d'accumulation de porteurs (5) et le substrat (1), en vue d'isoler électriquement le moyen d'accumulation de porteurs (5) et le substrat (1) l'un de l'autre ;

une première couche conductrice (10) formée au-dessus du moyen d'accumulation de porteurs (5) ; et

un second moyen d'isolement (9) disposé entre la première couche conductrice (10) et le moyen d'accumulation de porteurs (5), en vue d'isoler électriquement la première couche conductrice (10) et le moyen d'accumulation de porteurs (5) l'un de l'autre ;

ledit second élément actif (102) comportant

des troisième et quatrième régions semiconductrices ($13_1$, $13_2$) qui sont formées dans une région superficielle de la première région de puits (11) tout en étant isolées l'une de l'autre et qui sont du second type de conductivité ;

une seconde couche conductrice (15) formée au-dessus de la partie superficielle de la première région de puits (11) qui est située entre les troisième et quatrième régions semiconductrices ($13_1$, $13_2$) ; et

un troisième moyen d'isolement (14) situé entre la seconde couche conductrice (15) et la première région de puits (11), en vue d'isoler électriquement la seconde couche conductrice (15) et la première région de puits (11) l'une de l'autre ; et

ledit troisième élément actif (104) comportant des cinquième et sixième régions semiconductrices ($16_1$, $16_2$) qui sont formées dans une région superficielle de la seconde région de puits (12) tout en étant isolées l'une de l'autre et qui sont du premier type de conductivité ;

une troisième couche conductrice (18) formée au-dessus de cette partie superficielle de la seconde région de puits (12) qui est située entre les cinquième et sixième régions semiconductrices ($16_1$, $16_2$) ; et

un quatrième moyen d'isolement (17) disposé entre la troisième couche conductrice (18) et la seconde région de puits (12), pour isoler électriquement la troisième couche conductrice (18) et la seconde région de puits (12) l'une de l'autre.

8. Dispositif à semiconducteurs selon la revendication (7) caractérisé en ce que lesdits premier, second, troisième et quatrième moyens d'isolement (4, 9, 14, 17) comprennent des pellicules d'isolement, respectivement.

9. Dispositif à semiconducteurs selon la revendication 7 ou 8, caractérisé en ce que ledit moyen d'accumulation de porteurs (5) comprend une quatrième couche conductrice.

F I G. 1

EP 0 421 446 B1

F I G. 2A

F I G. 2B

F I G. 2C

F I G. 2D

EP 0 421 446 B1

F I G. 2E

F I G. 2F

EP 0 421 446 B1

F I G. 2G

F I G. 2H

FIG. 2I

FIG. 2J